(19) **Europäisches Patentamt European Patent Office Office européen des brevets**

(11) **EP 2 706 518 B1**

(12) **EUROPEAN PATENT SPECIFICATION**

(45) Date of publication and mention
of the grant of the patent:
**15.08.2018 Bulletin 2018/33**

(51) Int Cl.:
**G08B 29/12** *(2006.01)* **G01R 31/02** *(2006.01)*
**G08B 25/04** *(2006.01)*

(21) Application number: **12183380.0**

(22) Date of filing: **06.09.2012**

(54) **Alarm system loop monitoring**

**Alarmsystem-Regelkreisüberwachung**

**Contrôle de boucle du système d'alarme**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**12.03.2014 Bulletin 2014/11**

(73) Proprietor: **Honeywell International Inc.
Morris Plains, NJ 07950 (US)**

(72) Inventor: **Barson, Michael
Nuneaton, Warwickshire CV11 6WJ (GB)**

(74) Representative: **Fox-Male, Nicholas Vincent
Humbert
Patent Outsourcing Limited
1 King Street
Bakewell
Derbyshire DE45 1DZ (GB)**

(56) References cited:
**WO-A1-2009/087169      CH-A5- 581 363
US-A1- 2011 150 188**

Description

## FIELD OF THE INVENTION

The present invention relates to analogue addressable alarm systems especially fire systems, and a method of detecting faults in such systems.

## BACKGROUND OF THE INVENTION

This invention relates to the use of improved loop monitoring techniques in an analogue addressable fire alarm system.

Modern analogue addressable fire alarm systems use combined power transmission and data communications on a screened 2-wire loop between a control panel and a number of outstations or field devices. The control panel may also control a number of such loops, each of which could typically be 1km long. Common types of outstations are fire sensors (or fire detectors), manual call points, alarm devices like sounders, strobes and ancillary devices like interfaces. A typical loop may have 100 outstations, each of which is addressed by a loop controller, on a loop card, in the panel. The status of each outstation is continuously monitored so that fires or faults can be determined. If a fire is detected, the panel will go into an alarm state and all the alarm devices (or a selected number) will activate on particular loops.

Increasingly such loops are being used to power more devices over longer distances and with alarm devices which require significantly more power in the alarm state. The cable type, its length, conductor size, the number of outstations and the distribution of the outstations and in particular the distribution of the alarm devices are critical in ensuring that sufficient power can be supplied to the alarm devices and to ensure that reliable communications is maintained between all the outstations and the loop controller. While for a given system, the total loop resistance and capacitance could be calculated at the design stage to guarantee correct operation, the actual installed system may exceed the maximum allowed values. Typical reasons are: the installed cable length is longer than expected; and the particular cable used has excessive capacitance. A further complication occurs, in that analogue addressable fire alarm loops are normally protected from short circuits and partial short circuits by having an isolating device either in each outstation or in a number of selected isolating devices. As short-circuit isolators are designed to go open-circuit with a loss of power, it is almost never possible to even measure the resistance of both conductors, and the capacitance between them, in a 2-wire loop at the commissioning stage of the loop (after installation with the outstations fitted).

Due to the limited monitoring on a typical loop when it is operational, it is also not always possible to detect intrinsic problems until after the system is commissioned and handed over to the customer. A common problem encountered is that, with communication error rates being acceptably low during commissioning, if the cable parameters are causing a very marginal operation, excessive communication errors could result later as the communication timing changes due to temperature and aging or because the system have become very sensitive to external electrical noise sources.

In addition, during the normal operation of the system, faults could develop that may not be detected under non-alarm conditions, but could cause a reduction or even an immediate loss of the alarm functionally after the system has detected a fire and started to turn the alarm devices on. While many systems can detect a gross fault such as a total open circuit in the loop wiring (loss of continuity), as communications stop from one end of the loop from outstations downstream of the wiring break, a relatively small increase in the loop resistance is not normally detected, even although it could be critical for the correct operation of the system. Reliance is normally heavily placed on regular fire alarm tests being carried out; however while this is necessary anyway, it is quite a rudimentary test.

A further fault that often occurs when installing fire alarm cables is a short circuit from the earthed screen to one of the internal conductors. If the short-circuit occurs on the same leg as the short-circuit isolator (usually the positive conductor leg), then the fault can easily be located by the action of the short-circuit isolator (assuming each device has an isolator). If however, the earth fault is to the conductor without the isolators (usually the negative leg), then its location is difficult to find as it is likely to be at an outstation connection which could be typically at any of a 100 or more positions on the loop. Adding isolators in both conductor legs would enable the location of any earth fault to be found, however this would not only add cost, but would increase the loop resistance, reducing the available power that can be obtained by the alarm devices for a given loop length.

United States Patent Application Publication No. US 20110150188 describes a testing device for communication circuits for hazard alarm systems connected by a subscriber loop. The testing device has a subscriber simulation unit that is integrated into the communication circuit of the hazard alarm control center.

## SUMMARY OF THE INVENTION

The present invention is defined by the appended claims.

The system may include any one or more of the following features not forming part of the present invention:

- said current source arrangement is configured to remove the said inductive cancellations to measure the cables inductive impedance; and means to convert the 0V inductive impedance into a ratio with the 0V resistance of the cable to obtain a cable parameter substantially independent of cable length and indicative of poor cable management;

- if an earth wiring fault occurs on the 0V return wire, the system comprises means operable so that all outstations will serially communicate with the control panel in a sequential scan with the 0V return wire actively disconnected at both ends, so that only communication return currents flow in the section of cable between a particular scanned outstation and the earth fault;

- means operable so that the said disconnected ends of the 0V wiring will automatically reconnect to the control panel to provide a return path if the voltages on the disconnected ends increase to a value that could to cause a communication error;

- means operable to measure the resistance of each section of the 0V wiring between a particular outstation in the said sequential scan and the earth fault resistance as measured from each disconnected end, using processing to substantially reject the effect of cable ringing and pulse distortion from the resistance readings obtained to maintain the accuracy of the resistance readings over a large range of cable lengths;

- means operable to compare the said resistance readings obtained from both disconnected ends of the 0V wiring to determine the lowest combined impedance level and/or the most equal resistance values obtained for each outstation in the sequential scan, so that the position of the earth fault can be located to the nearest scanned outstation using this criteria;

- means operable to measure the impedance between each section of cable between each outstation during said sequential scan.

Thus, for example, the control station is operable to simulate an outstation for parameter readings to generate the communication low state in order that the measuring current flows, so enabling a parameter reading to be obtained.
The method may include the following steps not forming part of the invention:

- measuring the rise and fall times during the said simulated communication using a current source configured so that the cable capacitance and additional pulse distortion measurement can be calculated;

- configuring the current source arrangement to remove the said inductive cancellations to measure the cables inductive impedance, to converting the 0V inductive impedance into a ratio with the 0V resistance of the cable to obtain a cable parameter independent of cable length and indicative of poor cable management;

- wherein, if an earth wiring fault occurs on the 0V return wire, all outstations serially communicate with the control panel in a sequential scan with the 0V return wire actively disconnected at both ends, so that only communication return currents flow in the section of cable between a particular scanned outstation and the earth fault;

- the said disconnected ends of the 0V wiring automatically reconnect to the control panel to provide a return path if the voltages on the disconnected ends increase to a value to cause a communication error;

- measuring the resistance of each section of the 0V wiring between a particular outstation in the said sequential scan and the earth fault resistance as measured from each disconnected end, to reject the effect of cable ringing and pulse distortion from the resistance readings obtained to maintain the accuracy of the resistance readings over a large range of cable lengths;

- comparing the said resistance readings obtained from both disconnected ends of the 0V wiring to determine the lowest combined impedance level and/or the most equal resistance values obtained for each outstation in the sequential scan, so that the position of the earth fault can be located to the nearest scanned outstation using this criteria;

- measuring the impedance between each section of cable between each outstation during said sequential scan.

In the present invention, the loop wiring is continually and accurately tested for the D.C. resistance of both legs. The capacitance between the legs is also monitored and more importantly, the effect on the communications timing is also analysed due to the variation mainly in this parameter. This monitoring occurs during both the normal quiescent condition and alarm condition of the loop.

In addition, if an earth fault is detected on any of the conductors on any fire alarm loop, then the position can be located down to an individual outstation. This includes the negative conductor which is not isolated by a short-circuit isolator.

Due to the loop current requirements during quiescent and alarm conditions, it is normally very difficult to accurately measure the loop resistance, as the measuring current could be a small fraction of the total loop current; in addition, the loop communications normally causes a very large pulsed current to flow making readings unreliable. Other loads may also be placed across the loop wiring due to faults or due to the connection of unauthorised equipment, and which need to be independently monitored.

To overcome the above measurement problems, the resistance (and capacitance) is only measured when zero current is supplied to power any load on the loop. This condition will occur when a logic zero is transmitted, as the loop voltage will be pulled low, to a near-zero voltage. A measuring current from an accurate current source is arranged to flow in the loop wiring so that it is equal and opposite in each conductor leg to cancel out magnetic induction so that only the D.C. loop resistance is measured. The measuring current causes a voltage drop across the resistance of both conductor legs of the loop cable (including the resistance of the outstations on the loop). Both voltages are measured by the loop controller using an analogue to digital converter and a resistance value calculated. Not only can the calculated resistance values be compared to maximum allowed values, but the expected values for a particular loop can be analysed.

The capacitance of the loop cable (including the outstations) is calculated by measuring the time taken for the loop voltage to discharge to a threshold voltage and the time taken to charge back-up to a threshold voltage. As the voltage, current and delay times are known, then the capacitance can be calculated. More importantly the effect on the communication timing can be analysed.

Short-circuit earth faults to the negative conductor of any loop will bring up a general earth fault. To enable this earth fault to be repaired, the particular loop with the fault needs to be first located. If it is a multi-loop system, all the loops are re-allocated and - in the power-up sequence - no 0V connection is applied to the negative leg of any loop. The earth monitoring circuit can then bias the negative leg of the loop with the fault, to a positive voltage that can be detected by the loop controller of that particular loop card. Note that this process can happen automatically as the panel is powered-up.

When the loop with the earth fault is allocated (powered-up and addressed by the loop controller), the fault can then be located by connecting the screen earth to 0V using a MOSFET, then scanning all the outstations on the loop with the negative cable leg not connected to 0V by the loop card. This causes current from sources in the loop card to flow down the cable screen to 0V, as a particular outstation replies (with a logic low) to the loop controller. The outstation that causes the lowest combined voltage (and equal voltages) on both ends of the negative leg, will be at the short-circuit fault and is therefore located by the scan.

## APPLICATIONS OF THE PRESENT INVENTION

The present invention is applicable to analogue addressable fire alarm systems, and to loop-based systems with a building management system. Typical exemplary systems which may be applicable to the present invention include fire alarm panels, intruder systems, voice alarm systems, access control systems, nurse call systems, disabled toilet alarms and disabled refuge systems.

## ADVANTAGES OF THE PRESENT INVENTION

The method and system of the present invention provides accurate fault detection in analogue addressable fire systems in circumstances that have not previously been possible.

## BRIEF DESCRIPTION OF THE DRAWINGS

In order that the invention may more readily understood, a description is now given, by way of example only, reference being made to various embodiments of the present invention, in which:-

FIGURE 1 is a circuit diagram of the portion of an analogue addressable fire alarm system of the present invention when conducting a cable resistance test;
FIGURE 2 is a circuit diagram of the portion of an analogue addressable fire alarm system of the present invention when conducting a cable capacitance test;

**FIGURE 3** is a circuit diagram of the portion of an analogue addressable fire alarm system of the present invention when conducting a cable earth fault test.

**FIGURE 4** is a circuit diagram of the portion of an analogue addressable fire alarm system of the present invention when conducting an inductance test.

## DETAILED DESCRIPTION OF THE DRAWINGS

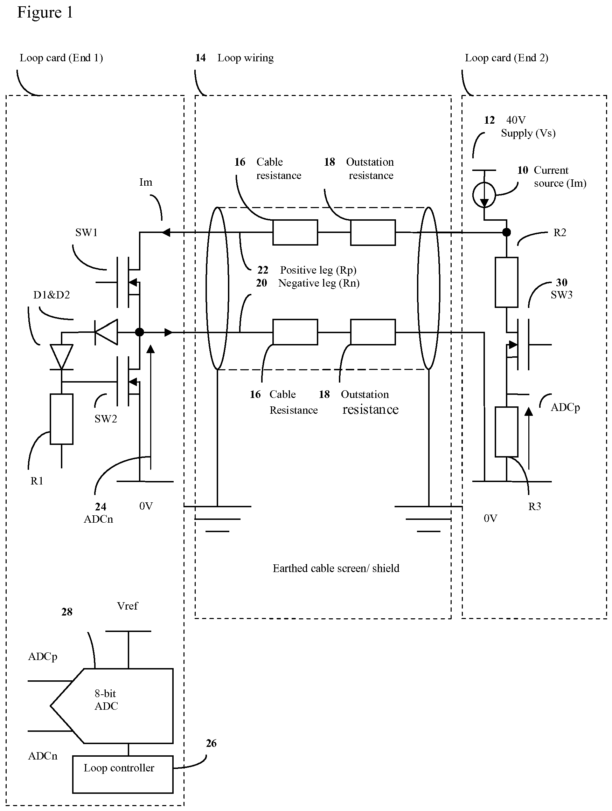

With reference to the cable resistance test operation shown in Figure 1, to accurately measure the loop resistances, an adjustable current source 10 (Im), supplies an accurate monitoring current from a nominal 40V supply voltage 12 to the loop wiring 14, which contains both the cable 16 and outstation 18 resistances. MOSFET transistor SW1 is switched-on at the same time as the 0V normally connected to the negative leg 20, and is switched off using MOSFET SW2. MOSFET SW3 is switched-on and then the voltage on the positive leg 22 of the cable (ADCp) and the voltage on the negative leg 24 of the cable (ADCn) are measured, both by the loop controller 26 using an 8 bit analogue-to-digital converter 28. The following calculations can then be done by the panel.

The negative leg resistance:

$$Rn = (ADCn/255 * Vref)/ Im \qquad Ohms$$

The total loop resistance:

$$RL = ((R2+R3)/R3)*(ADCp/255*Vref)/Im \qquad Ohms$$

The positive leg resistance:

$$Rp = RL - Rn \qquad Ohms$$

The average outstation isolator resistance in the positive leg:

$$Rb = (RL - 2Rn)/ N \qquad Ohms$$

Where N is the number of outstations on a loop and Vref is the reference voltage of the 8-bit ADC circuit.

If a very high resistance occurs in the negative leg, then to protect the measuring circuit from a high voltage on ADCn 24, MOSFET SW2 is automatically turned back-on by diodes D1 and D2, connected from the drain to gate, biasing R1 positive. To protect the measuring circuit from a high voltage on ADCp 22, MOSFET SW3 is arranged to automatically limit its source voltage 30. MOSFET SW3 is also switched off to block normal 40V loop communications.

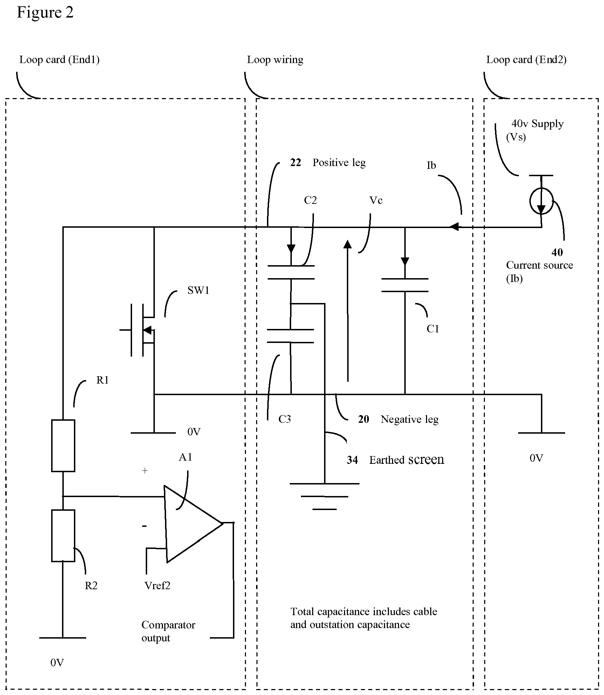

In Figure 2, the loop capacitance between the positive 22 and negative 20 legs is made up of the cable capacitance, which depends on the cable type and its length, plus the capacitance of all the outstations. The cable capacitance can also be increased if the screen 34 is connected to 0V; in this case, the full capacitance from the screen 34 to positive leg conductors appears in parallel with the capacitance between the conductors.

An adjustable current source 40 (Ib) is pulled low by MOSFET SW1 connected to 0V, a voltage comparator A1 then switches low as the loop voltage falls below a certain threshold voltage (Vth). The time taken for this to happen is measured and stored as T1. The MOSFET SW1 is then turned-off and the current source 40 is allowed to charge up the loop capacitance (Vc). As the voltage exceeds the threshold voltage Vth, the output of the voltage comparator A1 will switch positive. The time taken for this to happen is measured and stored as T2.

The threshold voltage (Vth) is given by:

$$Vth = Vref2 * (R1 + R2)/ R2$$

The total loop capacitance (Ct) is then given by:

$$Ct = Ib (T2-T1)/ Vth$$

This is made up of the leg-to-leg cable capacitance and outstation capacitance shown as C1 and the leg to screen capacitance shown as C2 and C3.

While this total capacitance value is useful feedback for installation, ensuring that the correct cable type and length is used, the delay time T2-T1 is also an important measurement as it is the effect of the capacitance. T2-T1 is a measurement of pulse distortion as compared to the ideal pulse width. Note that this value could be obtained using a lower than normal source current to increase accuracy and to ensure that under worst case conditions, the loop communication will have sufficient margin to run error free.

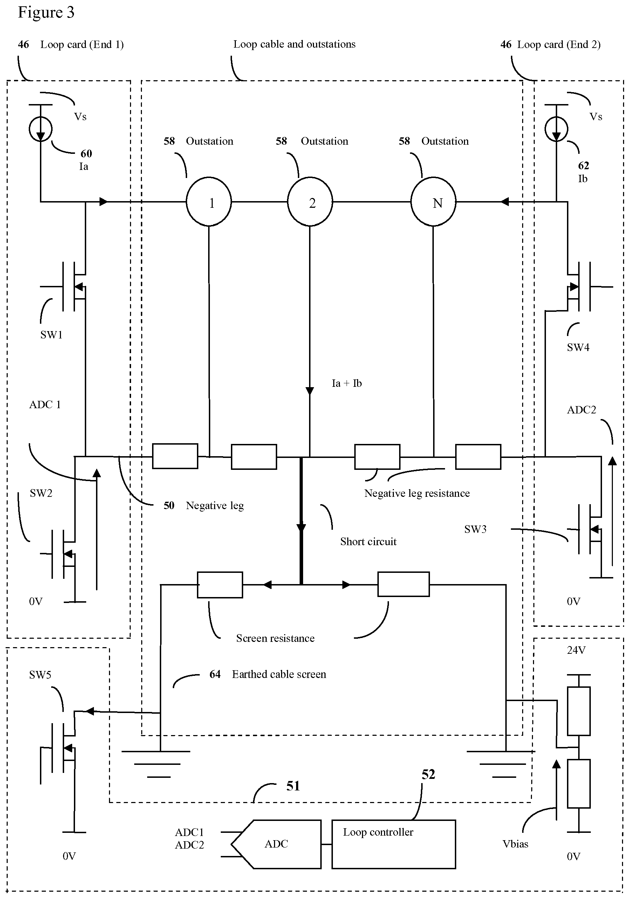

In Figure 3, short-circuit earth faults to the negative leg 50 of any loop 46 will bring up a general earth fault and will result in a search for its location. The location of a particular loop 46 with an earth fault will occur in the power-up sequence, where all the loop cards switch-off MOSFETS SW2, SW3 and SW5 connecting the 0V to the negative leg 50 of each loop 46. The earth monitoring circuit 51 can then bias the negative leg 50 of the loop 46 with the fault, to a positive voltage (Vbias). This voltage is detected by the loop controller 52 of that particular loop card, as ADC1 and ADC2 will be at Vbias.

A short circuit fault from the earthed screen 64 to the negative leg 50 on a particular loop 46 is located when the loop 46 is operational, by scanning all the outstations 58 on the loop 46 with SW5 on and both SW2 and SW3 turned off. Adjustable current sources 60, 62 (with respective currents Ia and Ib) are turned-on and supply a current Ia + Ib to the short circuit fault when any outstation 58 replies with a logic low, to the loop controller 52 (the outstation 58 turns-on a transistor allowing the Ia +Ib current to flow). This current flows down the cable screen 64 as a return path to 0V via SW5. The voltages at both ends of the negative leg 50 are measured and added together by the loop controller 52 (ADC1+ADC2).

Due to the effect of the loop cable inductance causing a leading edge over-shoot, multiple readings are taken on both of the voltages on the negative leg 50, after the loop controller 52 has received a reply from an outstation 58. The lowest reading at the end of the pulse waveform is used as ADC1 and ADC2 for that particular outstation. This over-shoot can also be measured in its own right to determine the inductance of the loop 46.

After scanning all of the outstations 58, both readings should be equal (or very close) and have the lowest combined reading of ADC1+ADC2 at the short-circuit point. If a number of outstations 58 meet these criteria, it is likely to be because more than one short-circuit fault is present on the loop 46. In this case, the panel can indicate the lowest (and highest) outstation number meeting the criteria and may display that more than one fault is present.

Earth faults at the panel (End 1 and End 2) can also be located by a similar technique. In the outstation scan, SW1 is pulsed-on to locate faults at end 1 (or outstation no. 0), while SW4 is pulsed-on to locate faults at end 2 (or outstation no. 255).

Note that the actual magnitude of the voltages measured will vary greatly with the position of the short-circuit on the loop 46, the loop length and the cable type used, however the minimum combined value of equal readings will always be at the fault, so that the fault can always be located down to the nearest outstation 58. As the fault is nearly always due to the wiring termination at an outstation 58 rather than in the cable between the outstations, and the spacing between outstations is usually more than 10m, the actual position located is usually very accurate.

The resistance of a short-circuit is normally very low (<0.1 Ohm) as compared to the higher cable resistance (typically > 10 Ohms) as it is commonly either a direct short from the negative leg 50 to the screen 64 or to an earthed metal back-box that the outstations 58 are mounted on to. The loop controller 52 however, can adjust current sources 60, 62 down, so that a relatively high resistance short fault can also be located.

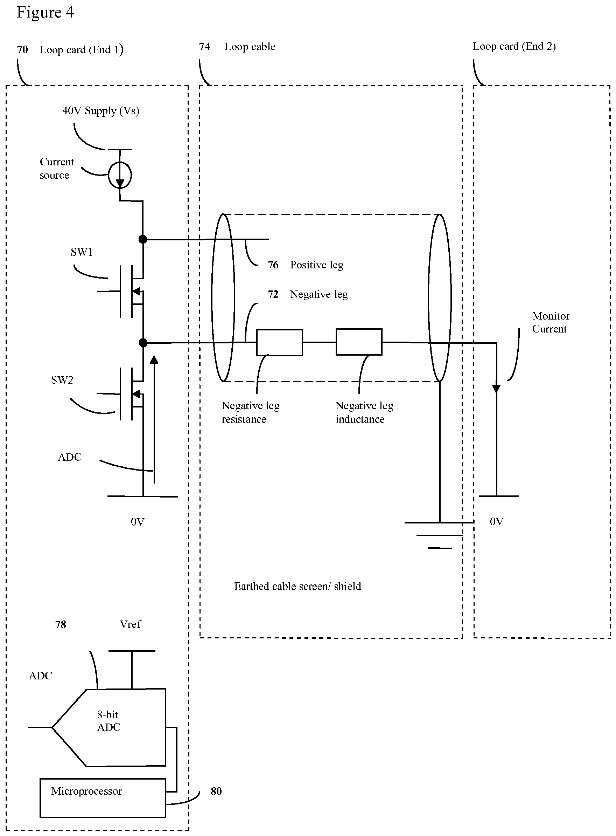

With reference to Figure 4, the circuit 70 is used to measure the inductive reactance and resistance of the negative leg 72 of the cable 74 whilst no current flows in the positive leg 76. SW1 is turned on, whilst SW2 is turned off, allowing a current to only flow in the negative leg 72. A high frequency A.C. component first flows in the negative leg 72 followed by a steady state D.C. current. The inductive reactance and resistance of the negative leg 72 will present a higher impedance when the A.C. current flows than to when the D.C. current flows, as the measured impedance when the D.C. current flows is only dependent on the resistance value.

A voltage (ADC) which is a measurement of the product of the monitor current and the negative leg impedance, is applied to an analogue-to-digital converter 78, under microprocessor 80 control. An impedance ratio measurement can then be obtained for the A.C. impedance to D.C. impedance. This ratio measurement relates directly to the per unit length inductance to resistance property of a particular cable, namely the correct cable type and its physical routing and separation to other circuits can be verified independently of its length.

While specific illustrated implementations of the present invention have been described above in relation to fire alarm systems, the present invention is equally relevant and applicable to other loop-based systems typically within a building management system, and also systems which include fire alarm panels, intruder detection systems, voice alarm systems, access control systems, nurse call systems, disabled toilet alarms and disabled refuge systems, and such systems will likewise benefit from the inherent advantages resulting from the present invention. Implementation of the present invention to these other forms of system would be evident to the skilled man. Thus, the present invention also provides an analogue addressable alarm system. The present invention furthermore also provides a method of testing an analogue addressable alarm system.

**Claims**

1. An analogue addressable fire alarm system comprising a 2-wire loop with combined power transmission and data communications, a control station and a plurality of outstations, means configured to apply a measuring current to the loop wiring for determination of the resistance, capacitance, inductance electrical characteristics of the loop wiring, **characterized in that** the means is configured to apply a measuring current when the signal for data communication on the loop wiring is in a low voltage state.

2. The system of claim 1 wherein the control station is operable to simulate an outstation for parameter readings to generate the communication low state.

3. The system of claim 1 or 2 wherein the means to apply the measuring current is operable to provide an inductive cancellation reading in the low state for resistive and capacitive readings.

4. The system of claim 1 or 2 wherein the means to apply the measuring current is operable to provide no cancellation for inductive readings.

5. The system of any preceding claim wherein the system is operable to scan sequentially all the outstations with wiring actively disconnected to find a fault current path and hence the location of an earth wiring fault.

6. The system of any preceding claim comprising means for regularly simulating an outstation communications of the communications protocol; control means operable to source configurable measuring currents arranged to provide inductive cancellation during a low state of the simulated communications that is at a low voltage for the measuring currents, independently of the alarm status of the fire alarm control panel.

7. The system of claim 6 comprising means operable to convert said measuring currents into monitored resistive cable parameters comprising: loop resistance; positive wire resistance; 0V wire resistance; total loop breaker resistance and average beaker resistance.

8. The system of claims 6 or 7 comprising means operable to measure the rise and fall times during the said simulated communication using a current source configured so that the cable capacitance and additional pulse distortion measurement can be calculated.

9. A method of testing an analogue addressable fire alarm system comprising a 2-wire loop with combined power transmission and data communications, a control station and a plurality of outstations, the method comprising applying a measuring current to the loop wiring for determination of the resistance, capacitance, inductance electrical characteristics of the loop wiring, **characterized in that** the step of applying a measuring current is performed when the signal for data communication on the loop wiring of the system is in a low voltage state.

10. The method of claim 9 wherein the control station simulates an outstation for parameter readings to generate the communication low state.

11. The method of claim 9 or 10 wherein the system provides an inductive cancellation reading in the low state for resistive and capacitive readings.

12. The method of any of claims 9 to 11 wherein the system provides no cancellation for inductive readings.

13. The method of any of claims 9 to 12 wherein the system scans sequentially all the outstations with wiring actively disconnected to find a fault current path and hence the location of an earth wiring fault.

14. The method of any of claims 9 to 13 wherein the system regularly simulates an outstation communications of the communications protocol, control means sourcing configurable measuring currents arranged to provide inductive cancellation during a low state of the simulated communications that is at a low voltage for the measuring currents, independently of the alarm status of the fire alarm control panel.

15. The method of any of claims 9 to 14 comprising converting said measuring currents into monitored resistive cable parameters comprising:
loop resistance; positive wire resistance; 0V wire resistance; total loop breaker resistance and average beaker resistance.

**Patentansprüche**

1. Analog adressierbares Feueralarmsystem, umfassend einen Zweidrahtkreis mit kombinierter Leistungsübertragung und Datenkommunikationen, eine Steuerstation und eine Vielzahl von Außenstationen, Mittel, konfiguriert zum Anlegen eines Messstroms an die Kreisverdrahtung zum Bestimmen elektrischer Charakteristika des Widerstands, der Kapazität und der Induktanz der Kreisverdrahtung, **dadurch gekennzeichnet, dass** das Mittel konfiguriert ist, einen Messstrom anzulegen, wenn das Signal für Datenkommunikation in der Kreisverdrahtung in einem Zustand niedriger Spannung ist.

2. System nach Anspruch 1, wobei die Steuerstation funktionsfähig ist, eine Außenstation für Parameterablesungen zu simulieren, um den niedrigen Zustand der Kommunikation zu erzeugen.

3. System nach Anspruch 1 oder 2, wobei das Mittel zum Anlegen des Messstroms funktionsfähig ist, eine induktive Auslöschungsablesung in dem niedrigen Zustand für resistive und kapazitive Ablesungen bereitzustellen.

4. System nach Anspruch 1 oder 2, wobei das Mittel zum Anlegen des Messstroms funktionsfähig ist, keine Auslöschung für induktive Ablesungen bereitzustellen.

5. System nach einem der vorstehenden Ansprüche, wobei das System funktionsfähig ist, sämtliche der Außenstationen mit aktiv getrennter Verdrahtung nacheinander abzutasten, um einen Fehlerstromweg und folglich den Ort eines Erdverdrahtungsfehlers zu finden.

6. System nach einem der vorstehenden Ansprüche, umfassend Mittel zum regelmäßigen Simulieren der Kommunikationen einer Außenstation des Kommunikationsprotokolls; Steuermittel, funktionsfähig zum Beziehen konfigurierbarer Messströme, angeordnet zum Bereitstellen induktiver Auslöschung während eines niedrigen Zustands der simulierten Kommunikationen, der an einer niedrigen Spannung ist, für die Messströme, unabhängig vom Alarmstatus der Feueralarmsteuertafel.

7. System nach Anspruch 6, umfassend Mittel, die funktionsfähig sind, die Messströme in überwachte resistive Kabelparameter umzuwandeln, umfassend: Kreiswiderstand; positiver Drahtwiderstand; 0-V-Drahtwiderstand; Kreisunterbrecher-Gesamtwiderstand und durchschnittlicher Becherwiderstand.

8. System nach Anspruch 6 oder 7, umfassend Mittel, die funktionsfähig sind, die Anstiegs- und Abfallzeiten der simulierten Kommunikation unter Verwendung einer Stromquelle zu messen, derart konfiguriert, dass die Kabelkapazität und zusätzliche Impulsverzerrungsmessung berechnet werden können.

9. Verfahren zum Testen eines analog adressierbaren Feueralarmsystems, umfassend einen Zweidrahtkreis mit kombinierter Leistungsübertragung und Datenkommunikationen, eine Steuerstation und eine Vielzahl von Außenstationen, das Verfahren umfassend Anlegen eines Messstroms an die Kreisverdrahtung zum Bestimmen elektrischer Charakteristika des Widerstands, der Kapazität und der Induktanz der Kreisverdrahtung, **dadurch gekennzeichnet, dass** der Schritt des Anlegens eines Messstroms durchgeführt wird, wenn das Signal für Datenkommunikation in der Kreisverdrahtung des Systems in einem Zustand niedriger Spannung ist.

10. Verfahren nach Anspruch 9, wobei die Steuerstation eine Außenstation für Parameterablesungen simuliert, um den niedrigen Zustand der Kommunikation zu erzeugen.

11. Verfahren nach Anspruch 9 oder 10, wobei das System eine induktive Auslöschungsablesung in dem niedrigen Zustand für resistive und kapazitive Ablesungen bereitstellt.

12. Verfahren nach einem der Ansprüche 9 bis 11, wobei das System keine Auslöschung für induktive Ablesungen bereitstellt.

**13.** Verfahren nach einem der Ansprüche 9 bis 12, wobei das System sämtliche der Außenstationen mit aktiv getrennter Verdrahtung nacheinander abtastet, um einen Fehlerstromweg und folglich den Ort eines Erdverdrahtungsfehlers zu finden.

**14.** Verfahren nach einem der Ansprüche 9 bis 13, wobei das System regelmäßig die Kommunikationen einer Außenstation des Kommunikationsprotokolls simuliert, Steuermittel konfigurierbare Messströme beziehen, angeordnet zum Bereitstellen induktiver Auslöschung während eines niedrigen Zustands der simulierten Kommunikationen, der an einer niedrigen Spannung ist, für die Messströme, unabhängig vom Alarmstatus der Feueralarmsteuertafel.

**15.** Verfahren nach einem der Ansprüche 9 bis 14, umfassend Umwandeln der Messströme in überwachte resistive Kabelparameter, umfassend:
Kreiswiderstand; positiver Drahtwiderstand; 0-V-Drahtwiderstand; Kreisunterbrecher-Gesamtwiderstand und durchschnittlicher Becherwiderstand.

## Revendications

**1.** Système d'alarme incendie adressable analogique comprenant une boucle à 2 fils de transmission de puissance et communication de données combinées, une station de commande et une pluralité de postes externes, un moyen d'application d'un courant de mesure au câblage en boucle pour la détermination des caractéristiques électriques de résistance, capacitance et inductance du câblage en boucle, **caractérisé en ce que** le moyen est configuré pour appliquer un courant de mesure quand le signal de communication sur le câblage en boucle est dans un état de basse tension.

**2.** Système selon la revendication 1 dans lequel la station de commande est exploitable pour simuler un poste externe de lectures de paramètres pour générer l'état bas de communication.

**3.** Système selon la revendication 1 ou 2 dans lequel le moyen d'application du courant de mesure est exploitable pour fournir une lecture de suppression inductive dans l'état bas pour des lectures résistives et capacitives.

**4.** Système selon la revendication 1 ou 2 dans lequel le moyen d'application du courant de mesure est exploitable pour ne fournir aucune suppression des lectures inductives.

**5.** Système selon l'une quelconque des revendications précédentes, le système étant exploitable pour balayer séquentiellement tous les postes externes ayant un câblage activement déconnecté pour trouver un chemin de courant de panne et ainsi l'emplacement d'une panne de câblage à la terre.

**6.** Système selon l'une quelconque des revendications précédentes comprenant un moyen de simulation régulière de communication de poste externe du protocole de communication ; un moyen de commande exploitable pour produire des courants de mesure configurables agencés pour fournir une suppression inductive durant un état bas des communications simulées qui est à une basse tension pour les courants de mesure, indépendamment de l'état d'alarme du panneau de commande d'alarme incendie.

**7.** Système selon la revendication 6 comprenant un moyen exploitable pour convertir lesdits courants de mesure en paramètres de câble résistif contrôlés comprenant : résistance de groupe ; résistance de fil positive ; résistance de fil à OV ; résistance totale de rupteur de boucle et résistance moyenne de rupteur.

**8.** Système selon les revendications 6 ou 7 comprenant un moyen exploitable pour mesurer les temps de montée et de chute durant ladite communication simulée en utilisant une source de courant configurée de telle sorte que la capacitance de câble et une mesure de distorsion d'impulsion supplémentaire puissent être calculées.

**9.** Procédé d'essai d'un système d'alarme incendie adressable analogique comprenant une boucle à 2 fils de transmission de puissance et communication de données combinées, une station de commande et une pluralité de postes externes, le procédé comprenant l'application d'un courant de mesure au câblage en boucle pour la détermination des caractéristiques électriques de résistance, capacitance, inductance du câblage en boucle, **caractérisé en ce que** l'étape d'application d'un courant de mesure est exécutée quand le signal de communication de données sur le câblage en boucle du système est dans un état de basse tension.

**10.** Procédé selon la revendication 9 dans lequel la station de commande simule un poste externe de lectures de paramètres pour générer l'état de communication bas.

**11.** Procédé selon la revendication 9 ou 10 dans lequel le système fournit une lecture de suppression inductive dans l'état bas pour les lectures résistives et capacitives.

**12.** Procédé selon l'une quelconque des revendications 9 à 11 dans lequel le système ne fournit aucune suppression des lectures inductives.

**13.** Procédé selon l'une quelconque des revendications 9 à 12, dans lequel le système balaye séquentiellement tous les postes externes ayant un câblage activement déconnecté pour trouver un chemin de courant de panne et ainsi l'emplacement d'une panne de câblage à la terre.

**14.** Procédé selon l'une quelconque des revendications 9 à 13 dans lequel le système simule régulièrement une communication de poste externe du protocole de communication, un moyen de commande produisant des courants de mesure configurables agencés pour fournir une suppression inductive durant un état bas des communications simulées qui est à une basse tension pour les courants de mesure, indépendamment de l'état d'alarme du panneau de commande d'alarme incendie.

**15.** Procédé selon l'une quelconque des revendications 9 à 14 comprenant la conversion desdits courants de mesure en paramètres de câble résistif contrôlés comprenant : résistance de groupe ; résistance de fil positive ; résistance de fil à OV ; résistance totale de rupteur de boucle et résistance moyenne de rupteur.

## Figure 1

Loop card (End 1)     **14**   Loop wiring      Loop card (End 2)

**12**   40V Supply (Vs)

**16**   Cable resistance     **18**   Outstation resistance

**10**   Current source (Im)

Im

SW1

R2

**22**    Positive leg (Rp)
**20**    Negative leg (Rn)

**30**
SW3

D1&D2

**16**   Cable Resistance     **18**   Outstation resistance

ADCp

SW2

R1

**24**
ADCn    0V

R3

0V

Earthed cable screen/ shield

**28**    Vref

ADCp

8-bit ADC

ADCn     Loop controller    **26**

Figure 2

Loop card (End1)　　　　　　　　Loop wiring　　　　　　　　　　Loop card (End2)

40v Supply
(Vs)

**22**　Positive leg　　　　　　　Ib

C2　　　Vc

SW1

R1

C1

0V

A1

C3　　　**20**　Negative leg

R2

**34**　Earthed screen

Vref2

Comparator
output

**40**
Current source
(Ib)

0V

Total capacitance includes cable
and outstation capacitance

0V

12

Figure 3

**46** Loop card (End 1)          Loop cable and outstations          **46** Loop card (End 2)

Vs

**60**
Ia

**58** Outstation    **58** Outstation    **58** Outstation

1        2        N

Vs

**62**
Ib

SW1

SW4

Ia + Ib

ADC 1

ADC2

SW2

**50** Negative leg

Negative leg resistance

SW3

0V

Short circuit

0V

SW5

Screen resistance

24V

**64** Earthed cable screen

**51**          **52**

ADC1
ADC2    ADC    Loop controller

Vbias

0V                                  0V

Figure 4

**70** Loop card (End 1)     **74** Loop cable     Loop card (End 2)

40V Supply (Vs)

Current
source

SW1

**76** Positive leg

**72** Negative leg

Monitor
Current

SW2

ADC

Negative leg
resistance

Negative leg
inductance

0V

0V

Earthed cable screen/ shield

**78**     Vref

ADC

8-bit
ADC

Microprocessor     **80**

**EP 2 706 518 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20110150188 A